# FASCICULE DE BREVET EUROPEEN

(11) **EP 2 347 481 B1**
(45) Date de publication et mention de la délivrance du brevet: **05.06.2013**
(21) Numéro de dépôt: 09755937.1
(22) Date de dépôt: 29.10.2009
(51) Int. Cl.: H01S 5/183, H01S 5/343, H01S 5/042

(54) **SYSTEME D'EMISSION DE LUMIERE SUIVANT UN MODE POLARITONIQUE AVEC INJECTION ELECTRIQUE DE PUITS QUANTIQUES**
SYSTEM ZUR LICHTEMISSION IN EINEM POLARITON-MODUS MIT ELEKTRISCHER EINSPEISUNG VON QUANTENTÖPFEN
SYSTEM FOR LIGHT EMISSION IN A POLARITON MODE WITH ELECTRICAL INJECTION OF QUANTUM WELLS

(30) Priorité: 13.11.2008 FR 0806323
(43) Date de publication de la demande: 27.07.2011
(73) Titulaire: Centre National de la Recherche Scientifique - CNRS, 75794 Paris Cedex 16 (FR)
(72) Inventeur: MALPUECH, Guillaume, F-63122 Manson (FR); SOLNYSHKOV, Dmitry, F-63400 Chamalières (FR); DI CARLO, Aldo, IT-00177 Rome (IT); PETROLATI, Eleonora, IT-00172 Rome (IT)
(74) Mandataire: Bethenod, Marc
(86) Numéro de dépôt international: PCT/FR2009/001257
(87) Numéro de publication internationale: WO 2010/055221

(56) Documents cités:
- WO-A-2005/088786
- US-A- 5 877 509
- G. CHRISTMANN ET AL: APPLIED PHYSICS LETTERS, vol. 93, no. 051102, 4 août 2008 (2008-08-04), pages 051102-1-051102-3, XP002539432 cité dans la demande
- WEIHS G ET AL: "Exciton-polariton lasing in a microcavity" SEMICONDUCTOR SCIENCE AND TECHNOLOGY, IOP, BRISTOL, GB, vol. 18, no. 10, 1 octobre 2003 (2003-10-01), pages S386-S394, XP002352635 ISSN: 0268-1242
- PETROLATI ET AL: "Simulation of exciton formation and transport in electrically driven polariton laser structures" SUPERLATTICES AND MICROSTRUCTURES, ACADEMIC PRESS, LONDON, GB, vol. 41, no. 5-6, 11 juin 2007 (2007-06-11), pages 364-367, XP022111939 ISSN: 0749-6036
- S I TSINTZOS ET AL: "A GaAs polariton light emitting diode operating near room temperature" NATURE, vol. 453, 15 mai 2008 (2008-05-15), pages 372-375, XP002539433 cité dans la demande
- A A KHALIFA ET AL: "electroluminescence emission from polariton states in GaAs based semiconductor microcavities" APLIED PHYSICS LETTERS, vol. 92, no. 061107, 13 février 2008 (2008-02-13), pages 061107-1-061107-3, XP002539434
- D SOLNYSHKOV ET AL: "Theory of an electrically injected bulk polariton laser" APPLIED PHYSICS LETTERS, vol. 94, no. 011110, 6 janvier 2009 (2009-01-06), pages 011110-1-011110-3, XP002539435
- R BUTTE ET AL: "Room temperature polariton lasing in III nitride microcavities a comparison with blue GaN basedf vertical cavity surface emitting lasers" PROCEEDINGS OF THE SPIE, THE INTERNATIONAL SOCIETY FOR OPTICAL ENGINEERING, no. 7216, 26 janvier 2009 (2009-01-26), pages 721619-1-721619-16, XP002539436 USA

## Description

La présente invention concerne un système d'émission de lumière suivant un mode polaritonique avec injection électrique de puits quantiques.

### DOMAINE TECHNIQUE

La présente invention se rapporte au domaine des sources lumineuses à semi-conducteurs utilisant des structures à puits quantiques en vue de l'obtention d'un effet de type « laser à polaritons ».

Elle se rapporte plus particulièrement à un système d'émission de lumière comprenant une cavité optique présentant au moins un mode optique et comprenant au moins un miroir transmissif, un premier ensemble de puits quantiques et des moyens d'injection électrique de ces puits quantiques du premier ensemble. Les puits quantiques du premier ensemble sont agencés de manière à ce qu'au moins une de leur résonances électroniques soit un régime de couplage fort avec un mode optique de ladite cavité optique et émette une lumière suivant un mode mixte exciton-polariton.

### ÉTAT DE LA TECHNIQUE ANTERIEURE

Les lasers à semi-conducteurs sont utilisés pour produire des faisceaux lumineux intenses et monochromatiques. Ils sont pompés à l'aide d'un courant électrique circulant dans une jonction P-N ce qui permet d'enrichir une cavité optique en électrons d'un côté et en trous de l'autre. Un faisceau lumineux est alors produit au niveau de la jonction par recombinaison des trous et des électrons. Le fonctionnement du laser est subordonné à la réalisation de la condition d'inversion de population, ce qui signifie que l'émission de lumière due à la recombinaison des paires électron-trous doit être supérieure à l'absorption due, elle, à la création de ces paires électron-trous. Cette condition détermine en partie le seuil de fonctionnement des lasers à semi-conducteurs, c'est-à-dire l'intensité minimum du courant électrique circulant dans la jonction pour que le laser puisse fonctionner. Un inconvénient de ces lasers réside dans le fait qu'ils présentent un seuil d'émission assez élevé, ce qui entraîne une perte d'énergie par échauffement, et dans certains cas, une grande difficulté, voire l'impossibilité d'obtenir l'effet laser.

Le laser à polaritons permet de s'affranchir d'un tel seuil. Il est basé sur le principe de la condensation de Bose-Einstein des exciton-polaritons, qui sont des quasi-particules de type exciton-photon existant dans les microcavités planaires en régime de couplage fort. Ce dispositif est communément appelé « laser » car il émet un faisceau lumineux comparable à celui d'un laser. Cependant, il est basé sur un principe de fonctionnement différent, à savoir la condensation des exciton-polaritons et non l'émission stimulée de photons. Aussi, la condition d'inversion de population, responsable du seuil dans un laser classique, n'a pas à être remplie pour un laser à polaritons, ce qui en fait intrinsèquement un laser à très bas seuil. Cela permet, en outre, de l'intégrer dans des microcircuits et d'augmenter la durée de vie des batteries des dispositifs portables. Le principe de fonctionnement d'un laser à polaritons a été pour la première fois proposé dans la publication « Phys. Lett. A 214 ; 193, 1996 » et étudié dans de nombreux articles depuis , dont par exemple la publication « Phys Rev Lett 101, 146404 (2008) ».

Pour réaliser un laser à polaritons viable commercialement, il est nécessaire de fabriquer un laser à polaritons injecté électriquement, ce qui n'a jamais été réalisé, et il est préférable de le faire fonctionner à température ambiante. Pour ce deuxième aspect, des semi-conducteurs présentant des excitons stables à température ambiante, tels que des matériaux de la famille de GaN peuvent être utilisés, comme décrit dans les publications « Phys. Rev. Lett. 98, 126405 (2007) », « Phys. Rev. Lett. 101,406409 (2008) » et « Appl. Phys. Lett. 93, 051102 (2008) ».

Il est possible de réaliser des microcavités dont la couche active est constituée dé matériau volumique pour lesquels l'effet laser à polaritons sous pompage optique a été observé, comme décrit dans la publication « Phys. Rev. Lett. 101,406409 (2008) ». Une autre solution consiste à réaliser une microcavité comprenant une couche active constituée de puits quantiques, ce qui en principe permet de réduire le seuil d'un facteur 10 par rapport à celui obtenu pour une structure volumique. Les puits quantiques sont des structures planaires aptes à confiner le mouvement des électrons et des trous suivant une direction de l'espace et à le laisser libre dans les deux autres directions. Ce confinement est discrétisé, ce qui donne lieu à des bandes d'énergie dont les valeurs d'énergie sont fonctions des dimensions des puits quantiques ainsi que des propriétés intrinsèques des matériaux les constituant. Ils peuvent être fabriqués notamment par épitaxie par jet moléculaire ou par dépôt chimique en phase vapeur.

D'autres particules comme les excitons peuvent être affectées de manière similaires par les puits quantiques. Le choix de la géométrie et du matériau constituant les puits quantiques permet de définir des niveaux d'énergie pour les électrons, les excitons, les trous, et autres. Ces particules peuvent se déplacer entre les niveaux d'énergie et par conséquent émettre et absorber des photons avec certaines énergies.

Une structure polaritonique à puits quantiques est décrite dans les documents de brevet EP 1 729 383 et EP 1 813 981. Dans ce dernier document, un système d'émission comprend un substrat sur lequel sont déposés successivement un premier miroir de Bragg, deux couches semi-conductrices entourant un puits quantique, et enfin un deuxième miroir de Bragg. L'ensemble forme ainsi une microcavité optique dans laquelle est disposé un puits quantique. La microcavité ainsi formée peut localiser spatialement un polariton et comprendre au moins trois niveaux discrétisés d'énergie pour polaritons.

Une autre structure est décrite dans le document de brevet US 5,877,509. Dans ce document, un système d'émission de lumière comprend une microcavité optique résonnante, un unique puits quantique et des moyens de transport résonnant. La cavité optique comporte deux miroirs de Bragg dont un est transmissif, des régions dopées N et P et une région d'espacement non dopée. Le puits quantique est disposé à l'intérieur de la cavité optique, de sorte à fournir au moins un niveaux d'énergie pour électrons, excitons, trous et polaritons. Le niveau d'énergie pour polaritons est obtenu lorsque l'énergie d'un photon est suffisamment proche de l'énergie du niveau d'énergie pour excitons. Des systèmes d'émission de lumière à partir d'états polaritoniques, basés sur des microcavités à multi-puits quantiques ont déjà été réalisés, comme divulgué dans les publications « Appl. Phys. Letters 92, 061107 (2008) », « Phys. Rev. B 77, 113303 (2008) », « Phys. Rev. Letters 100, 136806 (2008) » et « Nature 453, 372 (2008) ».

Néanmoins, les structures décrites ci-dessus permettent de réaliser une fonction de type diode électroluminescente. Elles ne permettent pas d'obtenir l'effet laser à polaritons. Ce dernier pour être réalisé nécessite d'utiliser des structures contenant un nombre élevé de puits quantiques couplés entre eux via le mode polaritonique, afin de maximiser le couplage lumière matière et faciliter la condensation de Bose-Einstein des polaritons. Ainsi, les principaux rapports d'effet lasers à polaritons ont été obtenus, sous pompage optique, dans les matériaux de la famille GaAs avec des structures contenant 12 puits quantiques (publication « Science 316, 1007 (2007) »), 26 puits quantiques dans CdTe (publication « Nature 443, 409 (2006) ») et 67 dans GaN (publication « Appl. Phys. Lett. 93, 051102 (2008) »). L'utilisation d'un grand nombre de puits a néanmoins l'inconvénient de rendre plus difficile, voire impossible, l'injection électrique des puits.

Dès lors, il se pose le problème de l'injection électrique des puits quantiques. En effet, d'une part, une injection efficace et homogène nécessite un petit nombre de puits quantiques dans la zone active. Cela s'explique par le fait que les électrons arrivent d'un côté et les trous de l'autre côté. Ceux-ci devant traverser tous les puits quantiques pour se rencontrer, l'injection est d'autant plus difficile qu'il y a de puits quantiques entre les électrons et les trous.

Par ailleurs, il paraît hautement favorable pour une commercialisation de réaliser un composant fonctionnant à température ambiante. Comme on l'a dit précédemment, les solutions les mieux développées consistent à utiliser des microcavités planaires réalisés à partir de semi-conducteur à grand gap comme par exemple la famille de GaN. Dans ce type de structure l'effet laser à polaritons, sous pompage optique a été rapporté. De plus, le nitrure de gallium permet une émission dans l'ultraviolet autour de 350 nanomètres, domaine de longueur d'onde où la réalisation d'un laser à semi-conducteurs reste compliquée.

Dans le cas de l'utilisation des matériaux de la famille de GaN, les problèmes d'homogénéité de l'injection électrique sont cruciaux car la mobilité des trous est beaucoup plus faible que celle des électrons. Typiquement, Il est difficile d'injecter efficacement un nombre de puits quantiques supérieur à quelques unités. D'autre part, un laser à polaritons doit contenir un grand nombre de puits quantiques comme on l'a dit précédemment. L'unique rapport de l'effet laser à polaritons à 300 K dans une structure à puits quantiques GaN l'a été pour une structure contenant 67 puits quantiques (publication « Appl. Phys. Lett. 93, 051102 (2008) »).

Cette contradiction entre l'injection électrique, nécessitant peu de puits, et l'obtention de l'effet laser à polaritons, nécessitant le plus possible de puits, rend inutilisable les géométries actuellement utilisées pour les lasers à semi-condcuteurs ou les lasers à polaritons pompés optiquement pour la réalisation d'un laser à polaritons pompé électriquement.

Ainsi aucune solution de l'état de la technique ne permet de réaliser un système efficace d'émission de lumière monochromatique et intense suivant un mode polaritonique par injection électrique de puits quantiques.

### OBJET DE L'INVENTION

Le but de la présente invention est de remédier à ce problème technique, en proposant d'insérer dans une cavité optique une quantité suffisante de puits quantiques pour pouvoir observer l'effet laser à polaritons, mais aussi un agencement particulier permettant un pompage électrique efficace de cette structure. Parmi l'ensemble des puits quantiques insérés, seulement une partie est disposée de sorte à subir une injection électrique, ce qui assure que l'injection s'opérera dans de bonnes conditions dans ces puits. L'autre partie de l'ensemble des puits quantiques est disposée de sorte à ne pas subir cette injection électrique de manière directe. Néanmoins, l'ensemble des puits participe dans le régime de couplage fort, et les puits injectés électriquement sont couplés optiquement aux autres puits, via l'existence du mode polaritonique étendu de la microcavité.

Les puits quantiques injectés vont alors émettre des photons dans le mode polaritonique, dans lequel participe l'ensemble des puits quantiques. Ces photons vont être absorbés par les puits quantiques non directement pompés. Le processus d'émission des photons par les puits injectés, puis d'absorption par les autres puits est très rapide en régime de couplage fort, typiquement deux ordres de grandeur plus court qu'en régime de couplage faible. C'est l'effet polaritons. Cette technique permet ainsi d'injecter électriquement, de manière efficace des polaritons dans une microcavité ayant un grand nombre de puits quantiques fortement couplés avec le mode optique.

La condensation des polaritons dans leur état de plus basse énergie est grandement facilitée lorsque le nombre de puits quantiques fortement couplés est élevé. L'invention permet donc d'injecter électriquement des polaritons dans ce type de structure. Le déclin radiatif spontané du condensat de polaritons résulte dans l'émission d'un faisceau de lumière monochromatique et intense, émission rendue possible par la transmissivité finie d'un des miroirs. L'approche de la solution a consisté à rechercher comment exploiter le régime de couplage fort nécessaire à l'obtention d'un effet polaritonique. Il est alors apparu qu'en utilisant ce régime de couplage pour faire interagir des puits quantiques injectés électriquement - en vue d'obtenir une émission de photons suivant un mode polaritonique - avec des puits quantiques non injectés, il était possible de n'injecter qu'un faible nombre de puits, le reste des puits pouvant être pompé optiquement par l'absorption des photons, ces puits pompés optiquement réémettant alors des photons directement suivant le même mode polaritonique.

Cette approche est d'autant plus inventive du fait qu'elle ne peut s'appliquer à un laser classique. En effet, les puits non pompés électriquement ne peuvent pas conduire à un inversement de population. Ils se contentent alors d'absorber la lumière, ce qui détruit l'effet laser. Au contraire, pour un laser à polaritons, l'absorption de la lumière est justement ce qui est recherchée et exploitée pour coupler optiquement les puits pompés avec les puits non pompés électriquement.

Dans ce but, l'invention a pour objet un système d'émission de lumière comprenant une cavité optique présentant au moins un mode optique et comprenant au moins un miroir transmissif, un premier ensemble de puits quantiques et des moyens d'injection électrique de ces puits quantiques du premier ensemble. Les puits quantiques du premier ensemble sont agencés de manière à ce qu'au moins une de leur résonances électroniques soit un régime de couplage fort avec un mode optique de ladite cavité optique et émette une lumière suivant un mode mixte exciton-polariton. Dans ce système, la cavité optique comprend également un deuxième ensemble de puits quantiques disposés hors de portée directe des moyens d'injection électrique et agencés par rapport auxdits puits quantiques du premier ensemble de manière à ce qu'au moins une de leurs résonances électroniques soit en régime de couplage fort avec ledit mode mixte exciton-polariton de ladite cavité optique.

L'homme du métier comprendra ici que les puits quantiques du deuxième ensemble ne sont pas injectés électriquement de manière directe, mais ne font qu'absorber et réémettre les photons émis par les puits quantiques du premier ensemble grâce à leur couplage via un mode polaritonique.

L'homme du métier comprendra également que l'émission de photons à l'extérieur de la cavité, et donc la génération de faisceau de lumière monochromatique et intense est due au déclin radiatif spontané du condensat de polaritons.

Cette solution combine avantageusement l'obtention du régime de couplage fort et la formation d'un mode polaritonique avec une disposition originale des puits quantiques. L'émission de photons suivant ce mode polaritonique permet de pomper optiquement les puits non injectés électriquement par absorption de ces photons, puis réémission de ceux-ci suivant le même mode polaritonique. On obtient alors un système comprenant une cavité optique résonnante dans laquelle une pluralité de puits quantiques sont insérés et tous participent à l'effet polaritons de sorte à obtenir une efficacité quantique d'autant plus grande. De surcroît, le faible nombre de puits quantiques injectés électriquement favorise l'obtention de l'effet laser à polaritons en diminuant les phénomènes d'écrantage et de déphasages dans les puits non pompés électriquement.

Selon un mode particulier de réalisation, la lumière est émise sous la forme d'un faisceau lumineux directionnel et monochromatique, constituant ainsi un laser dit « laser à polaritons ».

De préférence, le premier ensemble comporte un nombre de puits quantiques plutôt inférieur à 5, ce qui permet, de par le faible nombre de puits à injecter, de disposer d'une injection électrique homogène.

De préférence, le premier ensemble comporte un nombre de puits quantiques sensiblement inférieur au nombre de puits quantiques dans le deuxième ensemble. Ainsi, ces puits quantiques du deuxième ensemble étant fortement couplés à ceux du premier ensemble (injectés électriquement), l'effet laser à polaritons obtenu avec un tel nombre de puits sera d'autant plus important.

De préférence, les puits quantiques du premier et du deuxième ensemble sont identiques.

De préférence, la cavité optique comprend un miroir inférieur et un miroir supérieur disposés respectivement aux extrémités inférieure et supérieure de cette cavité optique. Le miroir supérieur est transmissif de sorte que la lumière émise par le système traverse ce miroir supérieur.

Selon une variante particulièrement avantageuse, les miroirs de la cavité optique sont des miroirs de Bragg, qui présentent l'avantage de donner lieu à de très faibles pertes optiques.

Selon un mode particulier de réalisation, la cavité optique comprend une région dopée P et une région dopée N.

Dans ce dernier cas, selon un mode particulier de réalisation, la cavité optique comprend une région d'espacement non dopée disposée entre les régions respectivement dopées N et P de la cavité optique.

Dans ce cas, les puits quantiques du premier ensemble et du deuxième ensemble sont respectivement disposés de la manière suivante :
- les puits quantiques du premier ensemble sont disposés entre la région d'espacement et la région dopée P de la cavité optique, et
- les puits quantiques du deuxième ensemble sont disposés entre la région dopée N et le miroir inférieur de la cavité optique.

Ainsi seuls les puits quantiques du premier ensemble sont compris entre les régions dopées N et P, qui sont celles entre lesquelles se produit l'injection électrique. Les puits quantiques du deuxième ensemble ne sont pas compris entre ces régions et ne sont donc pas pompés électriquement. Les puits du premier ensemble, pompés électriquement, vont ainsi générer des exciton-polaritons dans lesquels les puits du premier et du deuxième ensemble participent de manière égale, ce qui signifie que les photons émis par les puits du premier ensemble seront absorbés, puis réémis plusieurs fois par les puits du second ensemble avant de quitter la cavité optique.

Selon un mode particulier de réalisation, les moyens d'injection comprennent au moins une paire de contacts électriques reliés à une alimentation en courant.

Dans ce dernier cas, selon un mode particulier de réalisation, un contact d'une paire de contacts électriques des moyens d'injection est fixé à la région dopée N, l'autre contact étant fixé à la région dopée P.

Selon un mode particulier de réalisation, la cavité optique est déposée sur un substrat, ce qui permet de fabriquer sur ce dernier l'ensemble de la cavité.

De préférence, la cavité optique est planaire.

De préférence, la cavité optique est agencée de sorte que la lumière émise par le système soit perpendiculaire au miroir transmissif de la cavité optique. Cet effet peut être obtenu en disposant d'une cavité optique planaire, dont tous les éléments constitutifs sont plans et parallèles entre eux.

Selon un mode particulier de mise en oeuvre du système, les puits quantiques du premier et du deuxième ensemble sont constitués en des matériaux issus de la famille du nitrure de gallium, ce qui permet d'émettre une lumière à polaritons dans l'ultraviolet vers 350 nanomètres.

### BREVE DESCRIPTION DES DESSINS

L'invention sera mieux comprise à la lecture de la description détaillée d'un exemple non limitatif de réalisation, accompagnée de figures représentant respectivement :
- la figure 1, un schéma d'un système d'émission de lumière selon un mode particulier de réalisation de l'invention, et
- la figure 2, un schéma de représentant les mouvements des électrons et des trous au sein d'un système d'émission de lumière selon l'invention.

### EXPOSE DETAILLE DE MODES DE REALISATION PARTICULIERS

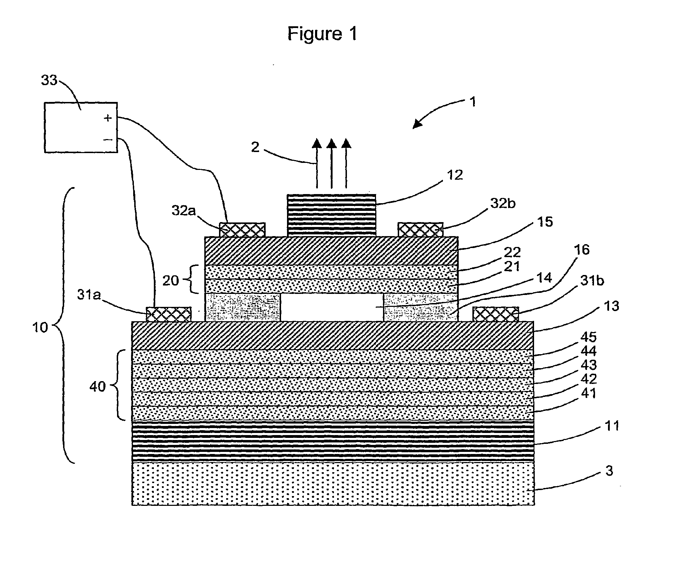

Comme illustré figure 1, le système 1 d'émission de lumière 2 selon un mode particulier de réalisation de l'invention comprend un substrat 3 et une cavité optique 10. Il est conçu pour fonctionner dans une longueur d'onde spécifique d'émission.

Dans ce mode de réalisation, le système comporte deux puits quantiques 21 et 22 injectés électriquement et cinq puits quantiques 41 à 45 non injectés. Ce choix de nombre de puits est imposé par la nécessaire clarté de la figure. Ainsi l'homme du métier sera à même de choisir un nombre de puits quantiques plus adéquat. En particulier, il pourra choisir un nombre de puits injectés inférieur à 5 et un nombre de puits non injectés nettement plus élevé qui pourra être de l'ordre de 60 pour une structure ayant des puits quantiques de GaN. L'homme du métier notera en effet qu'un grand nombre total de puits quantiques favorise l'effet laser à polaritons.

Ce système peut être obtenu suivant une technique d'épitaxie par jet moléculaire sur le substrat 3, qui est une technique bien connue de l'homme du métier. Un substrat adéquat peut être l'arséniure de gallium GaAs, ou le Saphir pour les structures réalisées à base de GaN.

La cavité optique 10 est une microcavité optique résonnante présentant au moins un mode polaritonique, correspondant à une émission de lumière par déclin radiatif spontané des polaritons, ce qui est rendu possible par la transmissivité finie d'un des deux miroirs. Cette cavité comporte, selon ce mode de réalisation :
- deux miroirs de Bragg 11 et 12,
- des régions 13 et 15 respectivement dopées N et P,
- une région d'espacement 14 non dopée,
- un premier ensemble 20 de puits quantiques 21 et 22,
- des moyens d'injection 31 à 33, et
- un deuxième ensemble 40 de puits quantiques 41 à 45.

Les deux miroirs de Bragg 11 et 12 sont disposés respectivement du côté inférieur et du côté supérieur de la cavité. Le miroir inférieur 11 est constitué par exemple d'une alternance de couches Al_{0.85}ln_{0,15}N et AlGaN, dont la réalisation est décrite par exemple dans la demande de brevet américain US 2007/003697, ou encore d'une alternance de couches Al_{0,58}Ga_{0,32}N et Al_{0,20}Ga_{0,80}N. Le miroir supérieur est constitué par exemple d'une alternance de couches diélectriques SiO₂ et SiN. Ces alternances sont illustrées sur la figure 1 par des successions de bandes noires et blanches. Chacune de ces couches alternées présente une épaisseur égale au quart de la longueur d'onde de la lumière 2 émise.

Ces deux miroirs 11 et 12 sont conçus pour réfléchir la lumière à la longueur d'onde d'émission du laser. Le miroir supérieur 12 présente par ailleurs des propriétés transmissives afin que la lumière 2 émise par le système puisse sortir de celui-ci en traversant ce miroir 12. On entendra ici par miroir transmissif un miroir présentant une transmissivité finie de sorte qu'une partie de la lumière émise puisse le traverser.

Ces miroirs de Bragg présentent l'avantage d'engendrer peu de perte d'énergie. Néanmoins, selon d'autres modes de réalisation, il peut être envisagé de remplacer ces miroirs de Bragg 11 et 12 par d'autres types de réflecteurs. Entre les miroirs de Bragg inférieur 11 et supérieur 12, la cavité optique 10 comporte un ensemble de couches intermédiaires. Ces couches sont successivement les puits quantiques 41 à 45 du deuxième ensemble, la région 13 dopée N, la région d'espacement 14 non dopée, les puits quantiques 21 et 22 du premier ensemble et la région 15 dopée P.

De manière préférée, toutes les couches et éléments de ce système sont planaires et parallèles entre eux. On s'assure ainsi que la lumière de sortie 2 sera émise dans une direction perpendiculaire au plan de référence du système.

La région 13 dopée N consiste en une couche d'AlGaN dopée N. De même, la région 15 dopée P consiste en une couche d'AlGaN dopée P. La région d'espacement 14 non dopée est constituée par une ouverture pratiquée dans une couche de AllnN. Cette ouverture permet de laisser passer le courant généré par les moyens d'injection et qui traverse une partie de la cavité. Le reste 16 de la couche de AlInN forme un tunnel pour diriger les électrons et les trous dans leurs mouvements lorsqu'un courant électrique est généré.

Les puits quantiques du premier et du deuxième ensemble sont constitués d'un mélange GaN/AlGaN avec 20% d'aluminium et leur épaisseur doit être faible, de l'ordre de quelques monocouches atomiques. Cette proportion d'aluminium permet de conserver une grande force d'oscillateur pour les excitons et de faire exister le régime de couplage fort.

L'homme du métier sera à même de réaliser les régions 13 à 15 ainsi que les puits quantiques dans d'autres matériaux ou alliages adéquats sans pour autant sortir du cadre du présent brevet. En particulier, il pourrait être réalisé d'autres mélanges à partir de nitrure de gallium pour réaliser les puits quantiques, comme du GaN/lnGaN. Le nitrure de gallium présente en effet la particularité de permettre une émission dans le bleu ou l'ultraviolet. Il pourrait également être utilisé un mélange à base d'arséniure de gallium, comme du AlGaAs/GaAs. D'autres matériaux peuvent être choisis, notamment en fonction de la longueur d'onde d'émission souhaitée. D'autres géométries peuvent être envisagées.

Par ailleurs, il convient de noter que les puits quantiques peuvent être similaires ou différents. En particulier, ils peuvent présenter des géométries différentes et être réalisés dans des matériaux différents.

Selon d'autres modes de réalisation, le puits quantique peut avoir la forme d'un fil quantique ou d'une boîte quantique. Il convient ici de noter que les confinements que confèrent un fil, un puits et une boîte quantiques sont respectivement d'une, de deux et de trois directions de l'espace. Les techniques de fabrication de telles structures quantiques sont connues de l'homme du métier.

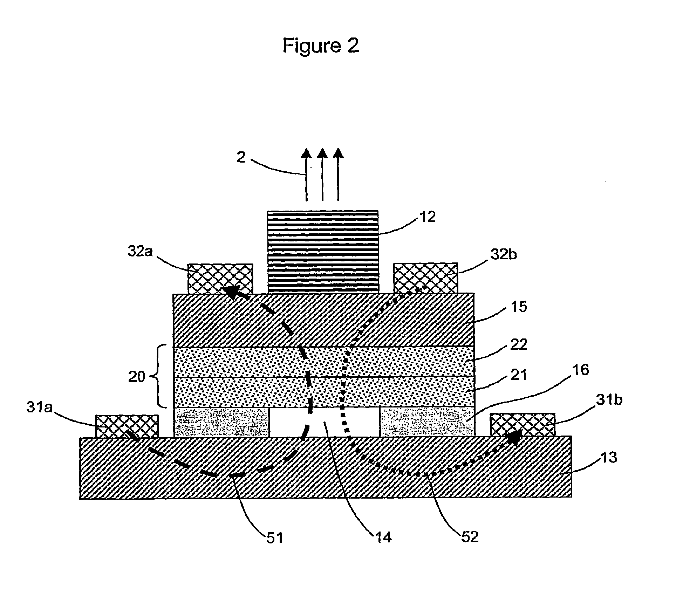

Les moyens d'injection 31 à 33 sont constitués de plusieurs contacts électriques alimentés par un générateur 33. L'ordre de grandeur des tensions générées par un tel générateur est d'environ 1,6 à 1,8 Volts, le courant traversant la cavité optique 10 dépendant alors des dimensions de la surface de cette cavité. Ces contacts électriques fonctionnent par paires (21 a,22a et 21 b,22b). Pour chaque paire, un contact 21 a (ou 21 b) est fixé à la région 13 dopée N - on parle alors de contact N - et l'autre contact 22a (ou 22b) est fixé à la région dopée P - on parle alors de contact P. La génération d'un courant électrique entre les deux contacts d'une même paire provoque alors un déplacement des électrons et des trous dans des sens opposés. Comme illustré figure 2, les électrons se déplacent du contact N vers le contact P (flèche 51) et les trous se déplacent du contact P vers le contact N (flèche 52).

La disposition des couches et des moyens d'injection fait que ce sont les puits quantiques 21 et 22 du premier ensemble qui subissent une injection électrique. Les puits quantiques 41 à 45 du deuxième ensemble ne sont ainsi pas injectés de cette manière. Par ailleurs, les puits quantiques du premier ensemble sont agencés de manière à ce qu'au moins une de leur résonances électroniques soit un régime de couplage fort avec un mode optique de ladite cavité optique et émette une lumière suivant un mode mixte exciton-polariton. Cet agencement des puits quantiques 21 et 22 est effectué par rapport aux moyens d'injection électrique, c'est-à-dire entre deux contacts électriques d'une même paire, ce qui permet d'émettre des photons suivant un mode polaritonique de la cavité.

Lorsqu'un courant électrique traverse les puits quantiques du premier ensemble, des électrons/excitons et des trous viennent peupler ces puits. Une résonance électronique/excitonique de chacun de ces puits s'opère alors en régime de couplage fort avec un des modes photoniques confinés de la cavité. De ce couplage fort résulte alors des quasi-particules appelées exciton-polaritons. Ces quasi-particules sont émises suivant le mode polaritonique de la cavité.

Les puits quantiques 41 à 45 du deuxième ensemble sont disposés hors de portée directe des moyens d'injection électrique et agencés par rapport aux puits quantiques du premier ensemble de manière à ce qu'au moins une de leurs résonances électroniques soit en régime de couplage fort avec ledit mode mixte exciton-polariton de la cavité optique 10. Ainsi les puits quantiques 41 à 45 du deuxième ensemble vont absorber puis réémettre suivant un mode polaritonique de la cavité optique les photons émis par les puits quantiques du premier ensemble. En effet, les puits quantiques sont disposés à l'extérieur de la zone d'injection définie par les contacts électriques 21 a et 22a des moyens d'injection. De plus, les puits quantiques 41 à 45 participent dans le même mode polaritonique que les puits quantiques 21 et 22. Ainsi ces puits quantiques 41 à 45 vont absorber les photons émis par les puits quantiques 21 et 22 suivant le mode polaritonique. Ces puits quantiques du deuxième ensemble vont alors se peupler d'excitons pour ensuite les émettre sous forme de photons suivant le même mode polaritonique de la cavité.

Dans le cas où le système est planaire et où tous les éléments le constituant sont parallèles entre eux, l'émission résultante de lumière issu des exciton-polaritons va alors s'opérer perpendiculairement à la surface supérieure de la cavité, c'est-à-dire la surface supérieure du miroir de Bragg supérieur 12.

Il convient ici de noter que pour une émission de lumière en mode polaritonique, celle-ci présente une dépendance non-linéaire par rapport à l'intensité du courant électrique d'injection (ou de pompage).

Un système d'émission de lumière selon l'invention permet d'obtenir une efficacité quantique très élevée, cette efficacité se définissant comme le rapport entre le nombre de photons émis dans une direction donnée et le nombre d'électrons ou de porteurs de charges injectés.

Ce système peut être utilisé dans un nombre important d'applications, par exemple pour des applications de stockage optique de données, notamment pour des lecteurs DVD. Dans ce dernier cas, l'utilisation d'un système avec des puits quantiques en nitrure de gallium GaN, émettant dans l'ultraviolet, permet d'augmenter le stockage.

Le bas seuil rend le dispositif peu consommateur et permet son utilisation dans des systèmes portatifs (ordinateurs portables, etc.) avec une meilleure autonomie des batteries, bien que le moteur joue aussi un rôle important dans la consommation.

Enfin, une autre application envisageable peut consister à intégrer un tel système laser à polaritons sur des microcircuits où les problèmes de dissipation de chaleur sont cruciaux.

Les modes de réalisation précédemment décrits de la présente invention sont donnés à titre d'exemples et ne sont nullement limitatifs. .

## Revendications

1. Système (1) d'émission de lumière (2) comprenant une cavité optique (10) présentant au moins un mode optique et comprenant au moins un miroir (12) transmissif, un premier ensemble (20) de puits quantiques (21,22) et des moyens (31,32,33) d'injection électrique desdits puits quantiques (21,22) du premier ensemble (20), lesdits puits quantiques (21,22) du premier ensemble (20) étant agencés de manière à ce qu'au moins une de leur résonances électroniques soit un régime de couplage fort avec un mode optique de ladite cavité optique (10) et émette une lumière (2) suivant un mode mixte exciton-polariton, **caractérisé en ce que** ladite cavité optique (10) comprend également un deuxième ensemble (40) de puits quantiques (41,42,43,44,45) disposés hors de portée directe desdits moyens (31,32,33) d'injection électrique et agencés par rapport auxdits puits quantiques (21,22) du premier ensemble (20) de manière à ce qu'au moins une de leurs résonances électroniques soit en régime de couplage fort avec ledit mode mixte exciton-polariton de ladite cavité optique (10).

2. Système (1) selon la revendication 1 dans lequel la lumière (2) est émise sous la forme d'un faisceau lumineux directionnel et monochromatique.

3. Système (1) selon la revendication 1 ou 2, dans lequel le premier ensemble (20) comporte un nombre de puits quantiques (21,22) sensiblement inférieur au nombre de puits quantiques (41,42,43,44,45) du deuxième ensemble (40).

4. Système (1) selon l'une des revendications 1 à 3, dans lequel les puits quantiques (21,22,41,42,43,44,45) du premier (20) et du deuxième (40) ensemble sont identiques.

5. Système (1) selon l'une des revendications 1 à 4, dans lequel la cavité optique (10) comprend un miroir (11) inférieur et un miroir (12) supérieur disposés respectivement aux extrémités inférieure et supérieure de ladite cavité optique (10), ledit miroir (12) supérieur étant transmissif de sorte que la lumière (2) émise par le système (1) traverse ledit miroir (12) supérieur.

6. Système (1) selon la revendication 5, dans lequel les miroirs (11,12) de la cavité optique (10) sont des miroirs de Bragg.

7. Système (1) selon l'une des revendications précédentes, dans lequel la cavité optique (10) comprend une région (13) dopée P et une région (15) dopée N.

8. Système (1) selon la revendication 7, dans lequel la cavité optique (10) comprend une région d'espacement (14) non dopée disposée entre les régions (13,15) respectivement dopées N et P de la cavité optique (10).

9. Système (1) selon la revendication 8, dans lequel les puits quantiques (21,22) du premier ensemble (20) sont disposés entre la région d'espacement (14) et la région (15) dopée P de la cavité optique (10).

10. Système (1) selon l'une des revendications 7 à 9, en dépendance de la revendication 5 ou 6, dans lequel les puits quantiques (41,42,43,44,45) du deuxième ensemble (40) sont disposés entre la région (13) dopée N et le miroir (11) inférieur de la cavité optique (10).

11. Système (1) selon l'une des revendications précédentes, dans lequel les moyens (31,32,33) d'injection comprennent au moins une paire (31 a,32a) de contacts électriques reliés à une alimentation (33) en courant.

12. Système (1) selon la revendication 11, en dépendance de l'une des revendications 7 à 10, dans lequel un contact (31 a) d'une paire (31a,32a) de contacts électriques des moyens (31,32,33) d'injection est fixé à la région (13) dopée N, l'autre contact (32a) étant fixé à la région (15) dopée P.

13. Système (1) selon l'une des revendications précédentes, dans lequel la cavité optique (10) est déposée sur un substrat (3).

14. Système (1) selon l'une des revendications précédentes, dans lequel la cavité optique (10) est planaire.

15. Système (1) selon l'une des revendications précédentes, dans lequel la cavité optique (10) est agencée de sorte que la lumière (2) émise par ledit système (1) soit perpendiculaire au miroir (12) transmissif de ladite cavité optique (10).

16. Système (1) selon l'une des revendications précédentes, dans lequel les puits quantiques (21,22,41,42,43,44,45) du premier (20) et du deuxième (40) ensemble sont constitués en des matériaux issus de la famille du nitrure de gallium.

## Patentansprüche

1. System (1) zur Emission von Licht (2), umfassend einen optischen Hohlraum (10), der mindestens einen optischen Modus aufweist, und umfassend mindestens einen durchscheinenden Spiegel (12), eine erste Gruppe (20) von Quantentöpfen (21, 22), und Mittel (31, 32, 33) zur elektrischen Injektion der Quantentöpfe (21, 22) der ersten Gruppe (20), wobei die Quantentöpfe (21, 22) der ersten Gruppe (20) derart angeordnet sind, dass mindestens eine ihrer elektronischen Resonanzen ein Zustand der starken Kopplung mit einem optischen Modus des optischen Hohlraums (10) ist und ein Licht (2) gemäß einem gemischten Exziton-Polariton-Modus emittiert, **dadurch gekennzeichnet, dass** der optische Hohlraum (10) auch eine zweite Gruppe (40) von Quantentöpfen (41, 42, 43, 44, 45) umfasst, die außerhalb der direkten Reichweite der Mittel (31, 32, 33) zur elektrischen Injektion angeordnet sind, und mit Bezug auf die Quantentöpfe (21, 22) der ersten Gruppe (20) so angeordnet sind, dass sich mindestens eine ihrer elektronischen Resonanzen im Zustand der starken Kopplung mit dem gemischten Exziton-Polariton-Modus des optischen Hohlraums (10) befindet.

2. System (1) nach Anspruch 1, wobei das Licht (2) in Form eines gerichteten und monochromatischen Lichtbündels emittiert wird.

3. System (1) nach Anspruch 1 oder 2, wobei die erste Gruppe (20) eine Anzahl von Quantentöpfen (21, 22) umfasst, die deutlich geringer als die Anzahl von Quantentöpfen (41, 42, 43, 44, 45) der zweiten Gruppe (40) ist.

4. System (1) nach einem der Ansprüche 1 bis 3, wobei die Quantentöpfe (21, 22, 41, 42, 43, 44, 45) der ersten (20) und der zweiten (40) Gruppe identisch sind.

5. System (1) nach einem der Ansprüche 1 bis 4, wobei der optische Hohlraum (10) einen unteren Spiegel (11) und einen oberen Spiegel (12) umfasst, die jeweils am unteren Ende und am oberen Ende des optischen Hohlraums (10) angeordnet sind, wobei der oberen Spiegel (12) durchscheinend ist, so dass das Licht (2), das vom System (1) emittiert wird, den oberen Siegel (12) durchquert.

6. System (1) nach Anspruch 5, wobei die Spiegel (11, 12) des optischen Hohlraums (10) Bragg-Spiegel sind.

7. System (1) nach einem der vorhergehenden Ansprüche, wobei der optische Hohlraum (10) einen dotierten Bereich P (13) und einen dotierten Bereich N (15) umfasst.

8. System (1) nach Anspruch 7, wobei der optische Hohlraum (10) einen nicht dotierten Abstandsbereich (14) umfasst, der zwischen den dotierten Bereichen (13, 15) N bzw. P des optischen Hohlraums (10) angebracht ist.

9. System (1) nach Anspruch 8, wobei die Quantentöpfe (21, 22) der ersten Gruppe (20) zwischen dem Abstandsbereich (14) und dem dotierten Bereich P (15) des optischen Hohlraums (10) angeordnet sind.

10. System (1) nach einem der Ansprüche 7 bis 9, in Abhängigkeit von Anspruch 5 oder 6, wobei die Quantentöpfe (41, 42, 43, 44, 45) der zweiten Gruppe (40) zwischen dem dotierten Bereich N (13) und dem unteren Spiegel (11) des optischen Hohlraums (10) angeordnet sind.

11. System (1) nach einem der vorhergehenden Ansprüche, wobei die Mittel (31, 32, 33) zur Injektion mindestens ein Paar (31 a, 32a) von elektrischen Kontakten umfassen, die mit einer Stromversorgung (33) verbunden sind.

12. System (1) nach Anspruch 11, in Abhängigkeit von einem der Ansprüche 7 bis 10, wobei ein Kontakt (31 a) eins Paars (31 a, 32a) von elektrischen Kontakten der Mittel (31, 32, 33) zur Injektion an den dotierten Bereich N (13) befestigt ist, wobei der andere Kontakt (32a) an den dotierten Bereich P (15) befestigt ist.

13. System (1) nach einem der vorhergehenden Ansprüche, wobei der optische Hohlraum (10) auf einem Substrat (3) abgelegt ist.

14. System (1) nach einem der vorhergehenden Ansprüche, wobei der optische Hohlraum (10) planar ist.

15. System (1) nach einem der vorhergehenden Ansprüche, wobei der optische Hohlraum (10) derart angeordnet ist, dass das Licht (2), das von dem System (1) emittiert wird, senkrecht zum durchscheinenden Spiegel (12) des optischen Hohlraums (10) ist.

16. System (1) nach einem der vorhergehenden Ansprüche, wobei die Quantentöpfe (21, 22, 41, 42, 43, 44, 45) der ersten (20) und der zweiten (40) Gruppe aus Materialien hergestellt sind, die aus der Familie des Galliumnitrids stammen.

## Claims

1. Light (2) emitting system (1) comprising an optical cavity (10) having at least one optical mode and comprising at least one transmissive reflector (12), a first set (20) of quantum wells (21, 22) and means (31, 32, 33) of electrical injection of said quantum wells (21, 22) of the first set (20), said quantum wells (21, 22) of the first set (20) being arranged in such a way that at least one of their electronic resonances is a strong coupling regime with an optical mode of said optical cavity (10) and emits a light (2) according to a mixed exciton-polariton mode, **characterized in that** said optical cavity (10) further comprises a second set (40) of quantum wells (41, 42, 43, 44, 45) arranged outside of the direct range of said means (31, 32, 33) of electrical injection and arranged in relation to said quantum wells (21, 22) of the first set (20) in such a way that at least one of their electronic resonances is in a strong coupling regime with said mixed exciton-polariton mode of said optical cavity (10).

2. System (1) according to claim 1 wherein the light (2) is emitted in the form of a directional and monochromatic light beam.

3. System (1) according to claim 1 or 2, wherein the first set (20) comprises a number of quantum wells (21, 22) substantially less than the number of quantum wells (41, 42, 43, 44, 45) of the second set (40).

4. System (1) according to one of claims 1 to 3, wherein the quantum wells (21, 22, 41, 42, 43, 44, 45) of the first (20) and of the second (40) set are identical.

5. System (1) according to one of claims 1 to 4, wherein the optical cavity (10) comprises a bottom reflector (11) and a top reflector (12) arranged respectively at the lower and upper ends of said optical cavity (10), said top reflector (12) being transmissive in such a way that the light (2) emitted by the system (1) passes through said top reflector (12).

6. System (1) according to claim 5, wherein the reflectors (11, 12) of the optical cavity (10) are Bragg reflectors.

7. System (1) according to one of the preceding claims, wherein the optical cavity (10) comprises a P-doped region (13) and an N-doped region (15).

8. System (1) according to claim 7, wherein the optical cavity (10) comprises an undoped gap region (14) arranged between the regions (13, 15) respectively N-doped and P-doped of the optical cavity (10).

9. System (1) according to claim 8, wherein the quantum wells (21, 22) of the first set (20) are arranged between the gap region (14) and the P-doped region (15) of the optical cavity (10).

10. System (1) according to one of claims 7 to 9, depending on claim 5 or 6, wherein the quantum wells (41, 42, 43, 44, 45) of the second set (40) are arranged between the N-doped region (13) and the bottom reflector (11) of the optical cavity (10).

11. System (1) according to one of the preceding claims, wherein the means (31, 32, 33) of injection include at least one pair (31 a, 32a) of electrical contacts connected to a supply (33) of current.

12. System (1) according to claim 11, depending on one of claims 7 to 10, wherein a contact (31 a) of one pair (31 a, 32a) of electrical contacts of the means (31, 32, 33) of injection is fixed to the N-doped region (13), the other contact (32a) being fixed to the P-doped region (15).

13. System (1) according to one of the preceding claims, wherein the optical cavity (10) is deposited on a substrate (3).

14. System (1) according to one of the preceding claims, wherein the optical cavity (10) is planar.

15. System (1) according to one of the preceding claims, wherein the optical cavity (10) is arranged in such a way that the light (2) emitted by said system (1) is perpendicular to the transmissive reflector (12) of said optical cavity (10).

16. System (1) according to one of the preceding claims, wherein the quantum wells (21, 22, 41, 42, 43, 44, 45) of the first (20) and of the second (40) set are constituted of materials coming from the gallium nitride family.
